# EUROPEAN PATENT SPECIFICATION

(11) **EP 3 806 610 B1**
(45) Date of publication and mention of the grant of the patent: **16.08.2023**
(21) Application number: 18921939.7
(22) Date of filing: 08.06.2018
(51) Int. Cl.: H05K 13/02, H05K 13/04

(54) **TAPE FEEDER**
BANDZUFÜHRER
DISPOSITIF D'ALIMENTATION DE BANDE

(43) Date of publication of application: 14.04.2021
(73) Proprietor: Fuji Corporation, Chiryu-shi, Aichi 472-8686 (JP)
(72) Inventor: KUNIHIRO, Tsutomu, Chiryu-shi, Aichi 472-8686 (JP); HOSOI, Norio, Chiryu-shi, Aichi 472-8686 (JP); TANAKA, Keita, Chiryu-shi, Aichi 472-8686 (JP); MURASE, Hiroki, Chiryu-shi, Aichi 472-8686 (JP)
(74) Representative: Grünecker Patent- und Rechtsanwälte PartG mbB
(86) International application number: PCT/JP2018/021982
(87) International publication number: WO 2019/234904

(56) References cited:
- EP-A1- 3 273 761
- WO-A1-98/32316
- JP-A- 2001 230 591
- JP-A- 2002 076 689
- JP-A- 2004 111 726
- JP-A- 2009 054 656
- US-A- 6 082 428

## Description

### Technical Field

The present specification discloses a technique relating to a tape feeder in which a magnet that applies a magnetic attraction force to a component of a component supply tape can be attached to a bottom face of a tape passage on which feeding to a component pickup position is performed with the component supply tape pulled out from a tape reel.

### Background Art

The component supply tape to be set in the tape feeder accommodates the components in component accommodating recessed sections formed on a carrier tape or the like at equal pitches, and is configured by adhering a top tape (top film) on an upper face of the carrier tape. The tape feeder, by pitch-feeding the component supply tape toward the component pickup position, peels off the top tape right in front of the component pickup position to sequentially expose and feed the component in each component accommodating recessed section of the component supply tape to the component pickup position, and at that position, mounts the component on a circuit board by picking up the component with a suction nozzle of component mounter.

During an operation of the tape feeder, the component in the component accommodating recessed section of the component supply tape may positionally deviate, be tilted, or be thrown out due to vibration and shock, or static electricity caused by a pitch-feeding operation of the component supply tape or peeling of the top tape, and this causes abnormal pickup such as component pickup error (pickup failure) or oblique pickup of the suction nozzle.

As a countermeasure, as described in Patent Literature 1 (JP-A-2007-27246), there is a method that by attaching a support plate with a magnet to a bottom face portion of a tape passage of a tape feeder, a component is attracted to the bottom face side of a component accommodating recessed section of a component supply tape by a magnetic attraction force of the magnet, and then the component in the component accommodating recessed section is prevented from positionally deviating, being tilted, or being thrown out.

Patent Application US 6 082 428 A relates to a component feed apparatus, which is fit for various kinds of usage, wherein a taping-component (i.e. a taped component or component tape) accommodating components at a predetermined pitch in a longitudinal direction of a tape, is moved along a component feed guide to stably and speedily supply the components to a predetermined position for mounting to an electronic circuit board.

### Patent Literature

Patent Literature 1: JP-A-2007-27246

### Summary of the Invention

### Technical Problem

Incidentally, since the tape feeder with the magnet can stabilize the orientation of the component in the component accommodating recessed section during tape feeding by a magnetic attraction force of the magnet, in the case where the magnet is attached, the tape feeding speed and the productivity can be increased as compared with a case without the magnet.

However, since the tape feeder itself cannot identify presence or absence of the magnet, when the tape feeding speed is changed depending on the presence or absence of the magnet during exchange operation of the tape feeder, it is necessary for an operator to visually check the presence or absence of the magnet and perform the operation of changing the tape feeding speed, but the operation is troublesome, and there is a possibility that an operational error may occur in which the operator mistakenly changes the tape feeding speed.

### Solution to Problem

The present invention is defined by the features of the independent claims, with preferred embodiments being specified in the dependent claims. References to embodiments which do not fall under the scope of the claims are to be understood as examples useful for understanding the invention.

With this configuration, since the tape feeder itself detects presence or absence of the magnet to change the tape feeding speed of the tape feeding device, it is not necessary for an operator to visually check the presence or absence of the magnet during an exchange operation of the tape feeder to perform an operation to change the tape feeding speed.

In particular, the productivity is increased since the tape feeder speed is increased in case a magnet is attached to the tape feeder as compared with case without the magnet.

### Brief Description of Drawings

[Fig. 1] Fig. 1 is a side view of a tape feeder showing an embodiment.
[Fig. 2] Fig. 2 is a perspective view of a detection device.
[Fig. 3] Fig. 3 is a block diagram showing a configuration of a control system of the tape feeder.
[Fig. 4] Fig. 4 is a longitudinal front view showing an enlarged holding structure at an upper end face portion of the tape feeder set in a feeder setting section of a component mounter.
[Fig. 5] Fig. 5 is a partially cutaway side view showing an enlarged clamping structure at the upper end face portion of the tape feeder set in the feeder setting section of the component mounter.
[Fig. 6] Fig. 6 is a flowchart showing a flow of processing of a tape feeding speed changing program.

### Description of Embodiments

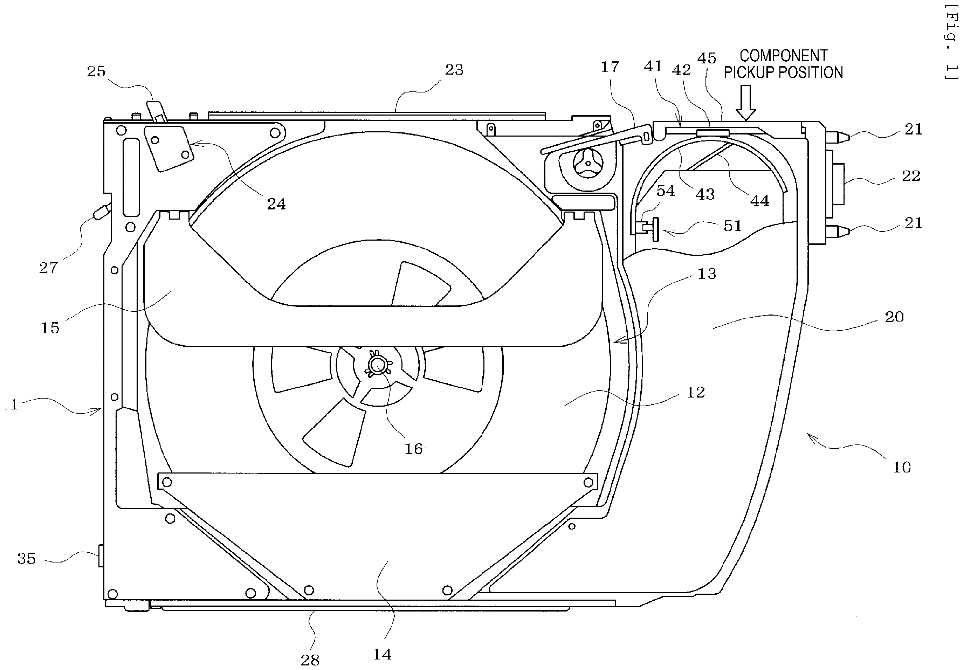

Hereinafter, an embodiment disclosed in the present specification is described using drawings. As shown in Fig. 1, in thin feeder main body 11 of tape feeder 10, reel holder 13 that exchangeably (detachably) loads tape reel 12 to which the component supply tape (not shown) is wound is provided. At a lower portion of reel holder 13, lower reel cover 14 that covers a lower portion of tape reel 12 loaded into reel holder 13 is provided. At an upper portion of reel holder 13, upper reel cover 15 that covers an upper portion of tape reel 12 loaded into reel holder 13 is provided such as to be opened and closed in a rotational manner with both sides of upper end portion as fulcrums.

When tape reel 12 is taken out from reel holder 13, upper reel cover 15 is rotated upward with both sides of the upper end portion as fulcrums to open an upper side of reel holder 13 and to allow the hand to grasp an upper side of tape reel 12 in reel holder 13 and pull out tape reel 12 obliquely upward while slightly tilting it outward. When tape reel 12 is loaded into reel holder 13, in reel holder 13 in which upper reel cover 15 is opened, a lower side of tape reel 12 is inserted into reel cover 14 from obliquely above and upper reel cover 15 is closed, so that the loading of tape reel 12 into reel holder 13 is completed.

In this case, a configuration may be adopted in which a short reel holding shaft (not shown) that fitted into center hole 16 of tape reel 12 is provided in the central portion of reel holder 13, such that tape reel 12 is rotatably supported by the short reel holding shaft. In a case where the configuration is adopted, in order to prevent the reel holding shaft, which is fitted into center hole 16 of tape reel 12, from hindering the detachability of tape reel 12, the length of the reel holding shaft is preferably set to shorter than the length of center hole 16 of tape reel 12 (for example, set to 1/2 to 1/3 of the length). Alternatively, a configuration may be adopted in which multiple rollers (not shown) are provided at a lower side of reel holder 13 along an outer circumference of tape reel 12, such that the outer circumference of tape reel 12 is rotatably borne and supported by the multiple rollers.

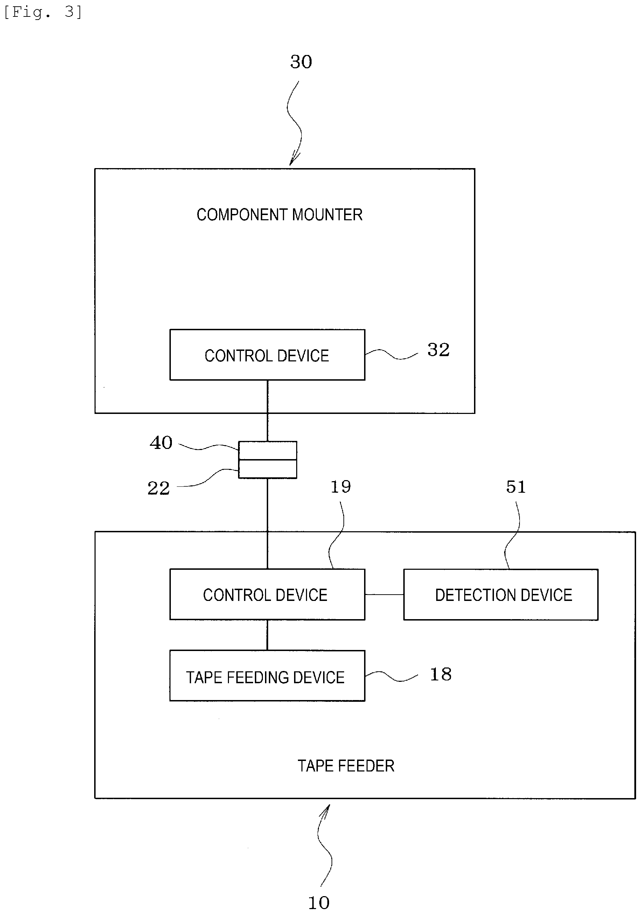

A component pickup position where a component is picked up with a suction nozzle (not shown) of component mounter 30 (see Fig. 3) is set at a position near an end face portion of an upper end face portion of feeder main body 11 on feeder main body 11 attachment direction side. Tape guide 17 that guides the component supply tape pulled out from tape reel 12 to the component pickup position is provided at a lower side of the upper end face portion of feeder main body 11.

In feeder main body 11, a space between reel holder 13 and the end face portion on feeder main body 11 attachment direction side serves as electrical equipment accommodating space 20. Electrical equipment accommodating space 20 is provided with various electrical equipment such as tape feeding device 18 (see Fig. 3) that pulls out the component supply tape from tape reel 12 in reel holder 13 and pitch-feeds the component supply tape to the component pickup position and control device 19 (see Fig. 3) that controls the pitch-feeding operation. Although not shown, tape feeding device 18 rotates and drives a sprocket using a motor such as a servomotor or stepping motor as a drive source, the sprocket is intermittently rotated by a predetermined rotation angle by engaging teeth of the sprocket with the feed hole of the component supply tape, so that the component supply tape is pulled out from tape reel 12 by one pitch and pitch-fed to the component pickup position. A tape feeding speed (rotation speed of the motor) of tape feeding device 18 can be changed by control device 19.

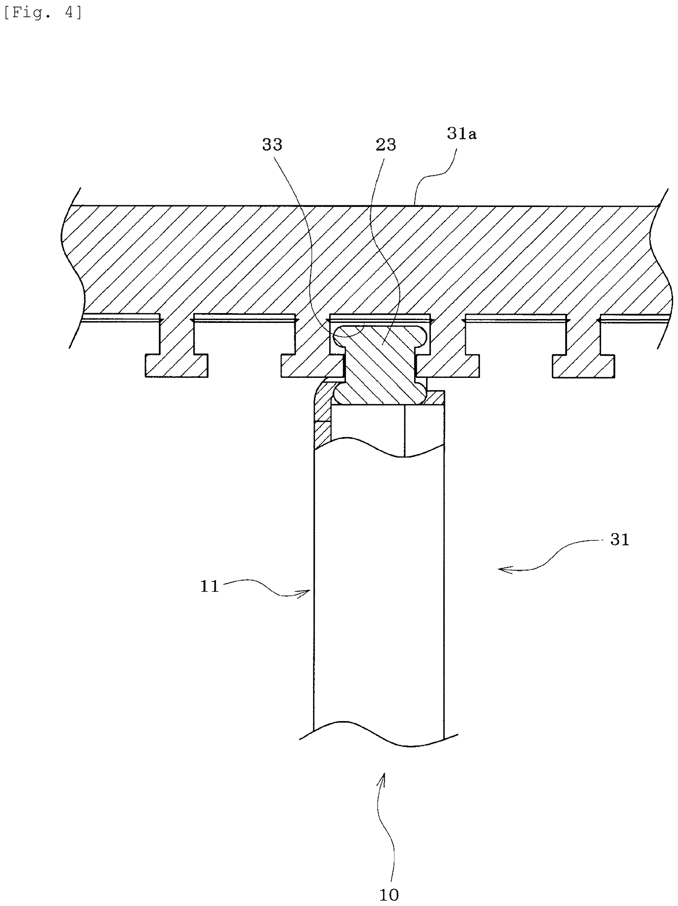

Two positioning pins 21, 21 (positioning sections) that perform positioning with respect to feeder setting section 31 (see Fig. 4) of component mounter 30 are provided at predetermined intervals in a vertical direction at a position higher than the center in a height direction of the end face portion on feeder main body 11 attachment direction side (in the present embodiment, a position near the upper end face portion of feeder main body 11). Connector 22 for both power supply and communication is provided between two positioning pins 21, 21 and, by inserting and connecting connector 22 of feeder main body 11 to connector 40 (see Fig. 3) of component mounter 30 side, power is supplied from component mounter 30 side to various electrical equipment such as tape feeding device 18 or control device 19 in feeder main body 11, and various signals such as control signals or sensor signals are transmitted and received between control device 32 (see Fig. 3) of component mounter 30 and control device 19 of feeder main body 11.

Next, a configuration in which feeder main body 11 is held in a set state (attached state) with respect to feeder setting section 31 of component mounter 30 is described.

On the upper end face portion of feeder main body 11, guide rail 23 having a T-shaped cross section is provided, as an upper holding member, such as to extend in an attachment and detachment direction of feeder main body 11. Correspondingly, as shown in Fig. 4, in member 31a of an upper side of feeder setting section 31 of component mounter 30, slot groove 33 having a T-shaped cross section into which guide rail 23 having a T-shaped cross section of feeder main body 11 is fitted in a slidably movable manner in the attachment and detachment direction of feeder main body 11 is provided such as to extend in the attachment and detachment direction of feeder main body 11, and, by fitting guide rail 23 having a T-shaped cross section of feeder main body 11 into slot groove 33 having a T-shaped cross section of feeder setting section 31, feeder main body 11 is held in a state where slide movement is guided in the attachment and detachment direction of feeder main body 11 and slipping down is prevented. In member 31a of the upper side of feeder setting section 31, multiple slot grooves 33 are provided at predetermined intervals, so that multiple feeder main bodies 11 can be set in feeder setting section 31.

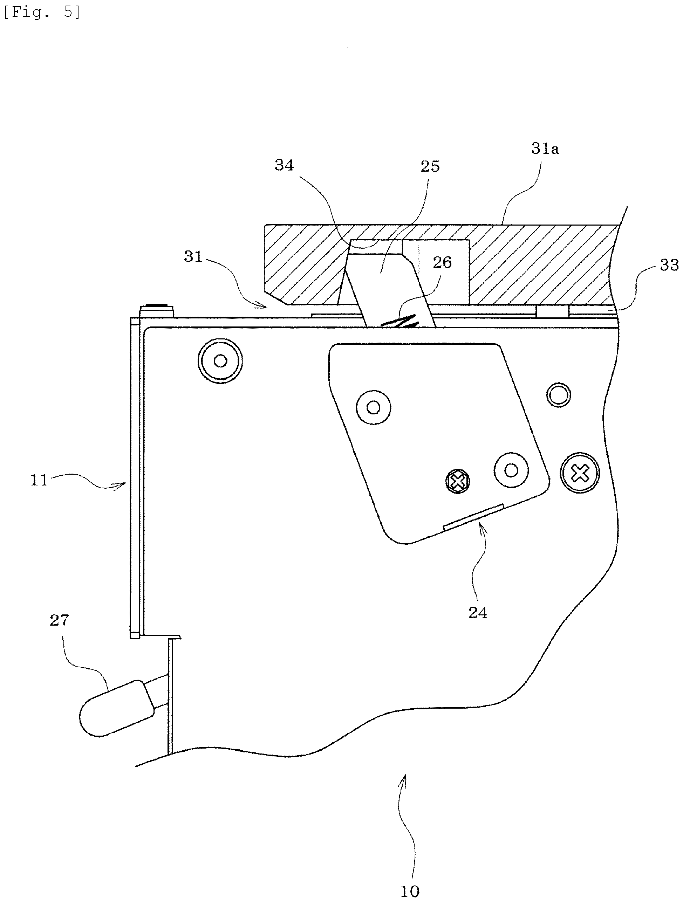

In addition, clamping device 24 (see Fig. 5) that clamps feeder main body 11 in an attached state with respect to feeder setting section 31 of component mounter 30 is provided at a position near an end face portion of the upper end face portion of feeder main body 11 on feeder main body 11 removal direction side. Clamping device 24 includes clamping member 25 that protrudes obliquely upward from the upper end face portion of feeder main body 11 during clamp operation, spring 26 that biases clamping member 25 obliquely upward, which is a clamp direction, and operation lever 27 (operation section) that operates a clamp release operation to retract clamping member 25 obliquely downward in a clamp release direction. Operation lever 27 is disposed such as to protrude from the end face portion on feeder main body 11 removal direction side.

On the other hand, clamp hole 34 (see Fig. 5) is provided at a position corresponding to clamping member 25 of member 31a of the upper side of feeder setting section 31 of component mounter 30, so that, by fitting clamping member 25 into clamp hole 34, feeder main body 11 is clamped in the attached state. In this case, as shown in Fig. 5, by pushing clamping member 25 obliquely upward on feeder main body 11 removal direction side with spring 26, an upper end portion of clamping member 25 is pressed against a side surface of clamp hole 34 on feeder main body 11 removal direction side, and due to the reaction, feeder main body 11 is pressed toward the attachment direction side, so that feeder main body 11 is positioned with high accuracy, and the connected state between connectors 22 and 40 are maintained.

As shown in Fig. 1, in a lower end face portion of feeder main body 11, guide rail 28 having an I-shaped cross section is provided, as a lower holding member, such as to extend in the attachment and detachment direction of feeder main body 11. Correspondingly, in a member (not shown) of a lower side of feeder setting section 31 of component mounter 30, a rail groove (not shown) having an I-shaped cross section into which guide rail 28 having an I-shaped cross section of feeder main body 11 is fitted in a slidably movable manner in the attachment and detachment direction of feeder main body 11 is provided, and, by fitting guide rail 28 having an I-shaped cross section of feeder main body 11 into the rail groove having an I-shaped cross section of feeder setting section 31, feeder main body 11 is held in a state where the slide movement is guided in the attachment and detachment direction of feeder main body 11 and pulling out upward is not prevented. In this manner, even when manufacturing variation in height dimension of feeder setting section 31 of component mounter 30 or manufacturing variation in height dimension of feeder main body 11 is increased to some extent, the friction resistance can be prevented from increasing during the slide movement of feeder main body 11 in the attachment and detachment direction, and feeder main body 11 can be smoothly attached and detached.

As shown in Fig. 1, in a bottom face of tape passage 41 that pitch-feeds the component supply tape pulled out from tape reel 12 to the component pickup position, plate-shaped magnet 42 that stabilize the orientation of the component during pitch-feeding by applying a magnetic attraction force to the component of the component supply tape is provided. Magnet 42 is fixed to flat spring 43 with adhesion or the like and is biased upward by an elastic force of flat spring 43. Thus, the component supply tape passing through tape passage 41 is pitch-fed to the component pickup position in a state of being sandwiched between tape pressing cover 45 that is provided in an upper face side of tape passage 41 and magnet 42.

A first end of flat spring 43 that biases magnet 42 upward is attached to the member on feeder main body 11 side by screws or the like, a long hole (not shown) extending in a longitudinal direction of flat spring 43 is formed on a second end side of flat spring 43, a screw (not shown) is inserted into the long hole and tightened into the member on feeder main body 11 side, so that the second end side of flat spring 43 is attached to feeder main body 11 side such as to be movable within a range of the long hole. In addition to flat spring 43, auxiliary spring 44 that auxiliarily pushes up magnet 42 is also provided. A configuration for biasing magnet 42 upward is not limited to a configuration using flat spring 43 and may be appropriately changed, for example, magnet 42 may be biased upward by a spring or the like.

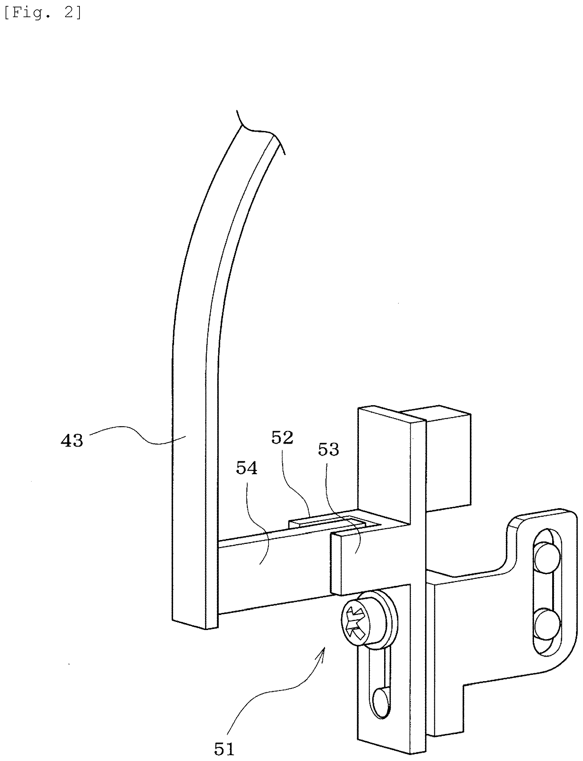

In the electrical equipment accommodating space 20, in addition to tape feeding device 18 or control device 19, detection device 51 that detects whether magnet 42 is attached is provided. As shown in Fig. 2, detection device 51 is constituted by, for example, a transmission photo sensor in which light emitting element 52 and light receiving element 53 are disposed to face each other. In the present embodiment, when flat spring 43 to which magnet 42 is fixed is attached to a predetermined position of feeder main body 11, dog section 54 provided in flat spring 43 is inserted between light emitting element 52 and light receiving element 53 of detection device 51 and a light path between light emitting element 52 and light receiving element 53 is in a shutoff state by dog section 54. With this, detection device 51 is configured to detect presence or absence of dog section 54 of flat spring 43 to detect presence or absence of magnet 42 depending on whether light receiving element 53 receives light from light emitting element 52.

Incidentally, detection device 51 may use a reflective photo sensor instead of the transmission photo sensor, and may further use a non-contact sensor such as a proximity sensor or a magnetic sensor instead of the photo sensor. In a case where the magnetic sensor is used, magnetic sensor detects presence or absence of a magnetic field generated from magnet 42 to detect the presence or absence of magnet 42. Alternatively, instead of the non-contact sensor, switches such as microswitches, or a contact sensor such as a contact displacement sensor may be used.

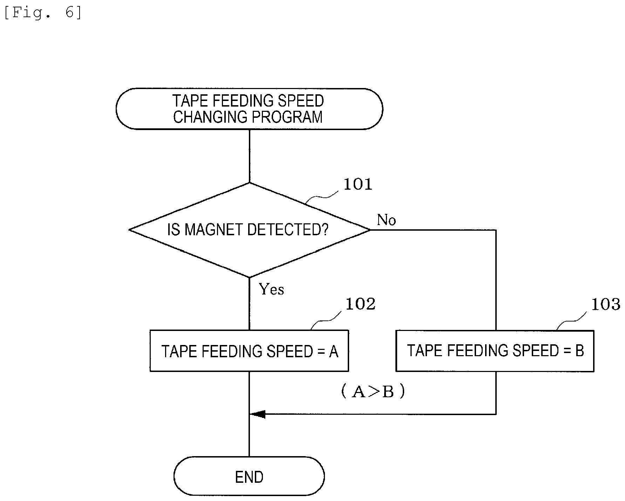

Control device 19 of tape feeder 10 is mainly configured by a microcomputer (CPU), and executes a tape feeding speed changing program (to be described later) shown in Fig. 6 when the power is charged, to change the tape feeding speed of tape feeding device 18 based on a detection result of detection device 51. Specifically, tape feeder 10 is set in feeder setting section 31 of component mounter 30 and connector 22 of tape feeder 10 is inserted and connected to connector 40 of component mounter 30 side and, when the power is charged from component mounter 30 side to tape feeder 10, control device 19 of tape feeder 10 executes the tape feeding speed changing program of Fig. 6. When the tape feeding speed changing program of Fig. 6 is started, first, control device 19 of tape feeder 10 determines whether magnet 42 is detected based on a detection signal of detection device 51 in Step S101, when it is determined that magnet 42 is detected, proceeds Step S102, sets the tape feeding speed of tape feeding device 18 to a high-speed side tape feeding speed A and ends the present program. Here, the high-speed side tape feeding speed A is set to a high tape feeding speed within a range in which the component of the component supply tape can be stably pitch-fed in a case where magnet 42 is present.

Meanwhile, when it is determined that magnet 42 is not detected in Step S101, the processing proceeds Step S103, the tape feeding speed of tape feeding device 18 is set to a tape feeding speed B lower than the tape feeding speed A in a case where magnet 42 is present, and the present program ends. The tape feeding speed B in a case where magnet 42 is not present is set to a tape feeding speed within a range in which the component of the component supply tape can be stably pitch-fed even without magnet 42.

According to the present embodiment described above, whether magnet 42 is attached to tape feeder 10 is detected by detection device 51 provided in tape feeder 10, the tape feeding speed of tape feeding device 18 is changed based on the detection result, and thus tape feeder 10 itself can detect the presence or absence of magnet 42 to change the tape feeding speed of tape feeding device 18. Therefore, it is not necessary for an operator to visually check the presence or absence of magnet 42 during an exchange operation of tape feeder 10 to perform an operation to change the tape feeding speed of tape feeding device 18, so that it is possible to reduce the labor of the operator who performs exchange operation of tape feeder 10, and also prevent an operational error in which the operator mistakenly changes the tape feeding speed.

In the above embodiment, only the tape feeding speed of tape feeding device 18 is changed depending on the presence or absence of magnet 42 detected by detection device 51, but in a case where a magnet is selected from multiple types of magnets with different magnetic attraction forces to the component of the component supply tape and is attached to tape feeder 10, the following configuration may be adopted. For example, a detection device is configured using a magnetic sensor, which is a sensor that detects the magnetic attraction force of magnet 42, and is configured to detect a magnitude of the magnetic attraction force of the magnet attached to tape feeder 10. Control device 19 of tape feeder 10 is configured to determine the presence or absence of the magnet based on a detection result of the detection device and, when it is determined that the magnet is attached, change the tape feeding speed of tape feeding device 18 depending on the magnetic attraction force of the magnet detected by the detection device. The larger the magnetic attraction force of the magnet (magnetic attraction force applied to the component of the component supply tape) detected by the detection device is, the higher the tape feeding speed of tape feeding device 18 may be set.

It is needless to say that the present invention is not limited to the embodiment and there may be various modifications within the limits of the appended claims for example, changing a configuration of tape feeder 10 of a configuration of detection device 51.

### Reference Signs List

10... tape feeder, 11... feeder main body, 12... tape reel, 18... tape feeding device, 19... control device of the tape feeder, 30... component mounter, 31... feeder setting section, 41... tape passage, 42... magnet, 43... flat spring, 51... detection device, 52... light emitting element, 53... light receiving element, 54... dog section

## Claims

1. A tape feeder (10) in which a magnet (42) that applies a magnetic attraction force to a component of a component supply tape is attachable to a bottom face of a tape passage (41) on which feeding to a component pickup position is performed with the component supply tape pulled out from a tape reel (12),
the tape feeder **characterized by**
a tape feeding device (18) configured to allow a tape feeding speed for feeding the component supply tape to be changed;
a detection device (51) configured to detect whether or not the magnet is attached, and
a control device (19) configured to:
- control the tape feeding speed of the tape feeding device so as to change the tape feeding speed based on a detection result of the detection device; and
- set a tape feeding speed (A), when it is determined that the magnet is attached based on the detection result, to be higher than a tape feeding speed (B) when it is determined that the magnet is not attached.

2. The tape feeder according to claim 1, wherein the detection device is configured to detect presence or absence of the magnet by detecting presence or absence of a member configured to attach the magnet to the tape feeder.

3. The tape feeder according to claim 1, wherein the detection device is configured to use a magnetic sensor configured to detect magnetism of the magnet attached to the tape feeder.

4. The tape feeder according to claim 3, wherein the magnet is selected from multiple types of magnets with different magnetic attraction forces to the component of the component supply tape and is attached to the tape feeder,
the detection device is configured to detect the magnetic attraction force of the magnet, and
the control device is configured to change the tape feeding speed of the tape feeding device depending on the magnetic attraction force of the magnet when it is determined that the magnet is attached based on the detection result.

## Patentansprüche

1. Band-Transportvorrichtung (10), bei der ein Magnet (42), der eine magnetische Anziehungskraft auf ein Bauteil eines Bauteil-Zuführbandes ausübt, an einer Bodenfläche eines Band-Durchlasses (41) angebracht werden kann, an dem Transportieren zu einer Bauteil-Aufnahmeposition durchgeführt wird, wobei das Bauteil-Zuführband von einer Bandspule (12) abgezogen wird,
wobei die Band-Transportvorrichtung **gekennzeichnet ist durch:**
eine Band-Transporteinrichtung (18), die so ausgeführt ist, dass sie zulässt, dass eine Band-Transportgeschwindigkeit zum Transportieren des Bauteil-Zuführbandes geändert wird;
eine Erfassungseinrichtung (51), die so ausgeführt ist, dass sie erfasst, ob der Magnet angebracht ist, sowie
eine Steuerungseinrichtung (19), die ausgeführt ist zum:
- Steuern der Band-Transportgeschwindigkeit der Band- Transporteinrichtung, so dass die Band-Transportgeschwindigkeit auf Basis eines Erfassungsergebnisses der Erfassungseinrichtung geändert wird; und
- Einstellen einer Band-Transportgeschwindigkeit (A), wenn auf Basis des Erfassungsergebnisses festgestellt wird, dass der Magnet angebracht ist, so dass sie höher ist als eine Band-Transportgeschwindigkeit (B), wenn festgestellt wird, dass der Magnet nicht angebracht ist.

2. Band-Transportvorrichtung nach Anspruch 1, wobei die Erfassungseinrichtung so ausgeführt ist, dass sie Vorhandensein oder Nichtvorhandensein des Magneten erfasst, indem sie Vorhandensein oder Nichtvorhandensein eines Elementes erkennt, das zum Anbringen des Magneten an der Band-Transportvorrichtung ausgeführt ist.

3. Band-Transportvorrichtung nach Anspruch 1, wobei die Erfassungseinrichtung so ausgeführt ist, dass sie einen Magnetsensor verwendet, der so ausgeführt ist, dass er Magnetismus des an der Band-Transportvorrichtung angebrachten Magneten erfasst.

4. Band-Transportvorrichtung nach Anspruch 3, wobei der Magnet aus mehreren Typen von Magneten mit unterschiedlichen magnetischen Anziehungskräften für das Bauteil des Bauteil-Zuführbandes ausgewählt wird und an der Band-Transportvorrichtung angebracht wird,
die Erfassungseinrichtung so ausgeführt ist, dass sie die magnetische Anziehungskraft des Magneten erfasst, und
die Steuerungseinrichtung so ausgeführt ist, dass sie die Band-Transportgeschwindigkeit der Band-Transporteinrichtung in Abhängigkeit von der magnetischen Anziehungskraft des Magneten ändert, wenn auf Basis des Erfassungsergebnisses festgestellt wird, dass der Magnet angebracht ist.

## Revendications

1. Alimentateur de bande (10) dans lequel un aimant (42) qui applique une force d'attraction magnétique à un composant d'une bande de fourniture de composant peut être fixé à une face inférieure d'un passage de bande (41) sur lequel l'alimentation vers une position de prise de composant s'effectue avec la bande de fourniture de composant tirée d'une bobine de bande (12),
l'alimentateur de bande étant **caractérisé par**
un dispositif d'alimentation de bande (18) configuré pour permettre le changement d'une vitesse d'alimentation de bande pour alimenter la bande de fourniture de composant ;
un dispositif de détection (51) configuré pour détecter si l'aimant est fixé ou non, et
un dispositif de commande (19) configuré pour :
- commander la vitesse d'alimentation de bande du dispositif d'alimentation de bande de manière à modifier la vitesse d'alimentation de bande sur la base d'un résultat de détection du dispositif de détection ; et
- régler une vitesse d'alimentation de bande (A), lorsqu'il est déterminé que l'aimant est fixé sur la base du résultat de détection, pour qu'elle soit supérieure à une vitesse d'alimentation de bande (B) lorsqu'il est déterminé que l'aimant n'est pas fixé.

2. Alimentateur de bande selon la revendication 1, dans lequel le dispositif de détection est configuré pour détecter la présence ou l'absence de l'aimant en détectant la présence ou l'absence d'un élément configuré pour fixer l'aimant à l'alimentateur de bande.

3. Alimentateur de bande selon la revendication 1, dans lequel le dispositif de détection est configuré pour utiliser un capteur magnétique configuré pour détecter le magnétisme de l'aimant fixé à l'alimentateur de bande.

4. Alimentateur de bande selon la revendication 3, dans lequel l'aimant est sélectionné parmi plusieurs types d'aimants avec différentes forces d'attraction magnétique pour le composant de la bande de fourniture de composant et est fixé à l'alimentateur de bande,
le dispositif de détection est configuré pour détecter la force d'attraction magnétique de l'aimant, et
le dispositif de commande est configuré pour modifier la vitesse d'alimentation de bande du dispositif d'alimentation de bande en fonction de la force d'attraction magnétique de l'aimant lorsqu'il est déterminé que l'aimant est fixé sur la base du résultat de détection.
